# EUROPEAN PATENT APPLICATION

(11) **EP 4 757 497 A1**
(43) Date of publication of application: **10.06.2026**
(21) Application number: 24848601.1
(22) Date of filing: 09.04.2024
(51) Int. Cl.: H05K 1/02, H05K 1/05, H05K 3/00

(54) **COLLECTIVE BOARD, METHOD FOR MANUFACTURING SAME, AND METHOD FOR MANUFACTURING CIRCUIT BOARD**

(30) Priority: 28.07.2023 JP 2023123824
(71) Applicant: NHK Spring Co., Ltd., Yokohama-shi, Kanagawa 236-0004 (JP)
(72) Inventor: TAKAKURA Mitsuaki, Yokohama-shi Kanagawa 236-0004 (JP)
(74) Representative: Oppermann, Frank
(86) International application number: PCT/JP2024/014434
(87) International publication number: WO 2025/027940

(57) **Abstract**

Provided is a collective board capable of improving work efficiency for obtaining individual circuit boards from a collective board in which the circuit boards are juxtaposed in a lattice shape. The collective board is provided with a product portion 3 in which a plurality of circuit boards 17 having a circuit pattern 15 on an insulating substrate 13 are juxtaposed in a first direction and a second direction intersecting each other in a lattice shape, a slit 7 spanning between at least ends of the product portion 3 in the first direction and penetrating, in a thickness direction, a portion between the circuit boards 17 adjacent to each other in the second direction, a coupling portion 9 coupling the circuit boards 17 adjacent to each other in the second direction at least at one end of the product portion 3 in the first direction, and grooves 11 spanning between ends of the product portion 3 in the second direction, being located between the circuit boards 17 and the coupling portion 9 adjacent to each other in the first direction and between the circuit boards 17 adjacent to each other in the first direction, and non-penetrating in the thickness direction.

## Description

### FIELD OF THE INVENTION

The present invention relates to a collective board in which a plurality of circuit boards are juxtaposed in a lattice shape and a method for manufacturing the same, and a method for manufacturing a circuit board.

### BACKGROUND OF THE INVENTION

As a method for manufacturing a circuit board, there is one that separates individual circuit boards from a collective board in which a plurality of the circuit boards are juxtaposed in a lattice shape.

When the individual circuit boards are separated, V-shaped grooves are formed on the collective board by a V-cut process as disclosed in Patent Literature 1, for example. The V-shaped grooves form thin portions between adjacent circuit boards to be fractured. According to the fracture of the thin portions, the individual circuit boards are separated and obtained.

In the collective board in which the circuit boards are juxtaposed in the lattice shape, an aggregate of the circuit boards in a row is separated from the lattice-shaped circuit board first, and the individual circuit boards are divided from the aggregate, however.

The conventional method for manufacturing a circuit board, therefore, causes increase of portions to be divided and the number of divisions and is deteriorated in work efficiency for obtaining the individual circuit boards.

### CITATION LIST

### PATENT LITERATURE

PATENT LITERATURE 1: JP2016-63201A

### SUMMARY OF THE INVENTION

### PROBLEMS TO BE SOLVED BY THE INVENTION

The problem to be solved is to deteriorate work efficiency for obtaining individual circuit boards from a collective board in which the circuit boards are juxtaposed in a lattice shape.

### MEANS FOR SOLVING THE PROBLEM

The present invention provides a collective board including a product portion in which a plurality of circuit boards each having a circuit pattern on an insulating substrate are juxtaposed in a first direction and a second direction intersecting each other in a lattice shape, a slit spanning between at least ends of the product portion in the first direction and penetrating, in a thickness direction, a portion between the circuit boards of the product portion adjacent to each other in the second direction, a coupling portion coupling the circuit boards adjacent to each other in the second direction at least at one end of the product portion in the first direction, and grooves spanning between ends of the product portion in the second direction, being located between the circuit boards and the coupling portion adjacent to each other in the first direction and between the circuit boards adjacent to each other in the first direction, and being non-penetrating in the thickness direction.

Further, the present invention provides a method for manufacturing a collective board, the collective board having a product portion in which a plurality of circuit boards each having a circuit pattern on an insulating substrate are juxtaposed in a first direction and a second direction intersecting each other in a lattice shape, a slit spanning between at least ends of the product portion in the first direction and penetrating, in a thickness direction, a portion between the circuit boards of the product portion adjacent to each other in the second direction, a coupling portion coupling the circuit boards adjacent to each other in the second direction at least at one end of the product portion in the first direction, and grooves spanning between ends of the product portion in the second direction, being located between the circuit boards and the coupling portion adjacent to each other in the first direction and between the circuit boards adjacent to each other in the first direction, and being non-penetrating in the thickness direction, including forming the slit and the non-penetrating grooves on a semi-finished product having the product portion.

Further, the present invention provides a method for manufacturing a circuit board using a collective board, the collective board having a product portion in which a plurality of circuit boards each having a circuit pattern on an insulating substrate are juxtaposed in a first direction and a second direction intersecting each other in a lattice shape, a slit spanning between at least ends of the product portion in the first direction and penetrating, in a thickness direction, a portion between the circuit boards of the product portion adjacent to each other in the second direction, a coupling portion coupling the circuit boards adjacent to each other in the second direction at least at one end of the product portion in the first direction, and grooves spanning between ends of the product portion in the second direction, being located between the circuit boards and the coupling portion adjacent to each other in the first direction and between the circuit boards adjacent to each other in the first direction, and being non-penetrating in the thickness direction, including holding both sides of the respective grooves in the first direction to fracture between the circuit boards and the coupling portion adjacent to each other and between the circuit boards adjacent to each other.

### EFFECT OF THE INVENTION

According to the present invention, it is possible to improve work efficiency for obtaining individual circuit boards from a collective board in which the circuit boards are juxtaposed in a lattice shape.

### BRIEF DESCRIPTION OF THE DRAWINGS

[FIG. 1] FIG. 1 is a schematic perspective view illustrating a collective board according to an embodiment 1 of the present invention.
[FIG. 2] FIG. 2 is a plan view of the collective board of FIG. 1.
[FIG. 3] FIG. 3 is a sectional view taken along a line III-III of the collective board of FIG. 2.
[FIG. 4] FIG. 4 is a sectional view taken along a line IV-IV of the collective board of FIG. 2.
[FIG. 5] FIG. 5 is a schematic perspective view illustrating formation of slits in the collective board according to the embodiment of the present invention.
[FIG. 6] FIG. 6 is a schematic perspective view illustrating formation of grooves in the collective board according to the embodiment of the present invention.
[FIG. 7] FIG. 7 is a side view illustrating cutters at the time of the formation of the slit in FIG. 5.
[FIG. 8] FIG. 8 is an enlarged front view illustrating a portion VIII in FIG. 7.
[FIG. 9] FIG. 9 is a schematic sectional view of the cutters of FIG. 7.
[FIG. 10] FIG. 10 is a side view of the cutters at the time of the formation of the groove in FIG. 6.
[FIG. 11] FIG. 11 is a schematic sectional view of the cutters of FIG. 10.
[FIG. 12] FIG. 12 is a schematic perspective view illustrating cleaning of the collective board according to the embodiment 1.
[FIG. 13] FIG. 13(A) and FIG. 13(B) are photographs illustrating an intersection of the slit and the groove of the collective board according to the embodiment 1 with enlargement.
[FIG. 14] FIG. 14(A) to FIG. 14(C) are perspective views illustrating a method for manufacturing the circuit board according to the embodiment 1.
[FIG. 15] FIG. 15 is a schematic sectional view illustrating the method for manufacturing the circuit board according to the embodiment 1.
[FIG. 16] FIG. 16 is a plan view of a collective board according to an embodiment 2 of the present invention.
[FIG. 17] FIG. 17 is a plan view of a collective board according to a modification of the embodiment 2.
[FIG. 18] FIG. 18 is a plan view of a collective board according to another modification of the embodiment 2.

### EMBODIMENT FOR CARRYING OUT THE INVENTION

The object of improving work efficiency for obtaining individual circuit boards from a collective board in which the circuit boards are juxtaposed in a lattice shape is accomplished by arranging a slit and a groove in combination between adjacent circuit boards.

A collective board 1 is provided with a product portion 3, a slit 7, a coupling portion 9, and grooves 11.

The product portion 3 is one in which a plurality of circuit boards 17 each having a circuit pattern 15 on an insulating substrate 13 are juxtaposed in a first direction and a second direction intersecting each other in a lattice shape. The slit 7 spans between at least ends of the product portion 3 in the first direction and penetrates, in a thickness direction, a portion between the circuit boards 17 of the product portion 3 adjacent to each other in the second direction. The coupling portion 9 couples the circuit boards 17 adjacent to each other in the second direction at least at one end of the product portion 3 in the first direction. The grooves 11 span between ends of the product portion 3 in the second direction, are located between the circuit boards 17 and the coupling portion 9 adjacent to each other in the first direction and between the circuit boards 17 adjacent to each other in the first direction, and are non-penetrating in the thickness direction.

In an embodiment, the coupling portion 9 may be provided along the second direction at each end of the product portion 3 in the first direction. In another embodiment, the coupling portion 9 may be provided along the second direction at one end of the product portion 3 in the first direction. In still another embodiment, a part of the coupling portion 9 may be provided at one end of the product portion 3 in the first direction and another part of the coupling portion may be provided at the other end of the product portion 3 in the first direction.

The method of manufacturing the collective board 1 forms the slit 7 and the grooves 11 in the semi-finished product 27 having the product portion 3. Preferably, the grooves 11 are formed after forming the slit 7. After the slit 7 and the grooves are formed, fluid F may be injected to the product portion 3. In this case, the slit 7 may be gradually reduced in width toward an intermediate portion of the product portion 3 in the thickness direction.

The method of manufacturing the circuit board 17 using the collective board 1 holds both sides of the respective grooves 11 in the first direction to fracture between the circuit board 17 and the coupling part 9 adjacent to each other and between the circuit boards 17 adjacent to each other. The holding is preferably performed for each row along the second direction.

### EMBODIMENT 1

### [Collective board]

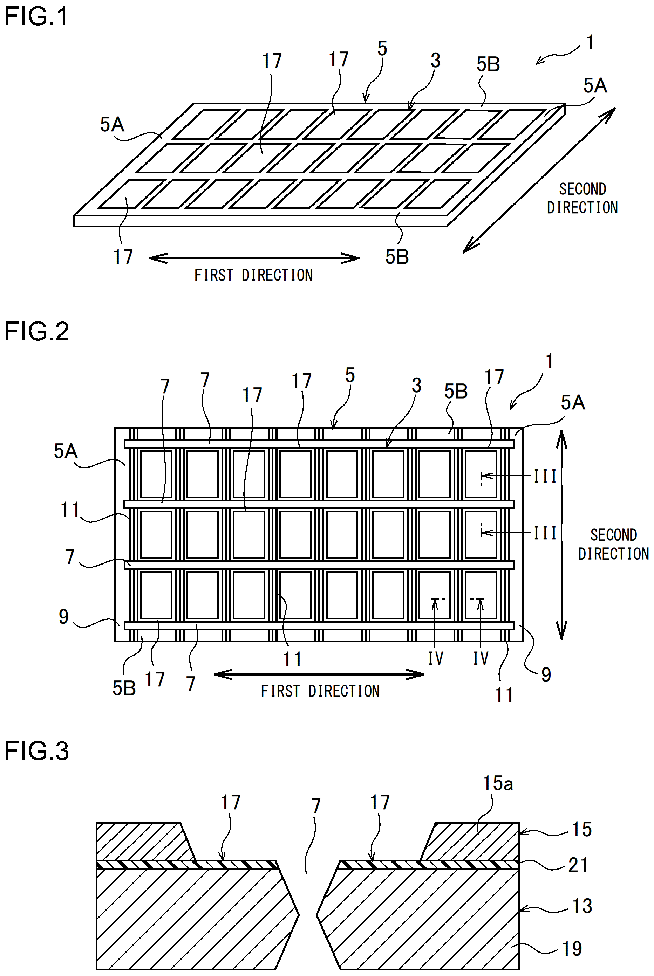

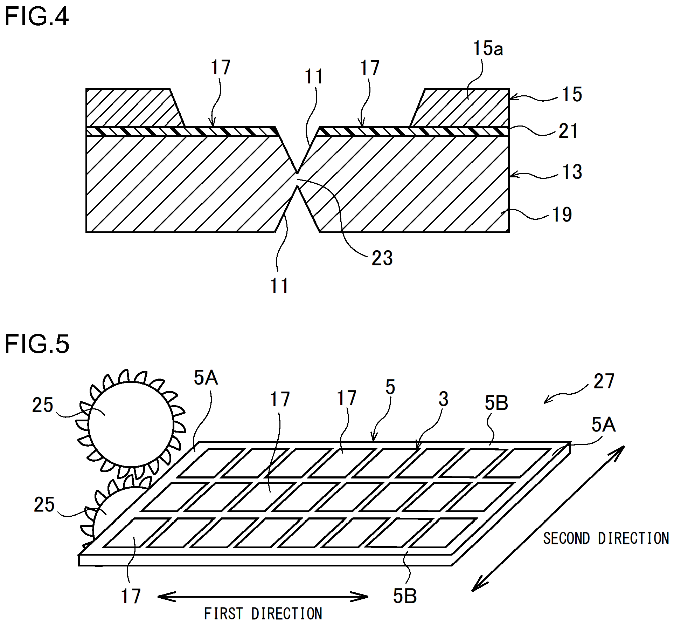

FIG. 1 is a schematic perspective view illustrating a collective board according to the embodiment 1 of the present invention. FIG. 2 is a plan view of the collective board of FIG. 1. FIG. 3 is a sectional view taken along a line III-III of the collective board of FIG. 2. FIG. 4 is a sectional view taken along line IV-IV of the collective board of FIG. 2.

As illustrated in FIG. 1 to FIG. 4, a collective board 1 is provided with a product portion 3, a frame portion 5, a plurality of slits 7, coupling portions 9, and a plurality of grooves 11. In addition, illustration of the slits 7 and the grooves 11 is omitted in FIG. 1.

The product portion 3 is one in which a plurality of circuit boards 17 each having a circuit pattern 15 on an insulating substrate 13 are juxtaposed in a first direction and a second direction intersecting each other in a lattice shape. The insulating substrate 13 is a metal-based substrate in which an insulating layer 21 is laminated on a metal base 19 in the present embodiment. The insulating substrate 13, however, may be another insulating substrate such as a ceramic substrate.

On an outer periphery of the product portion 3, the frame portion 5 is provided circumferentially. The frame portion 5 includes frame parts 5A at ends in the first direction and frame parts 5B at ends in the second direction of the product portion 3. The frame portion 5 serves as waste plates outside the product. It should be noted that the frame parts 5B at the ends in the second direction may be omitted.

The circuit boards 17 of the product part 3 are partitioned into the lattice shape by the plurality of the slits 7 and the plurality of the grooves 11.

The plurality of the slits 7 are spanned between the ends of the product portion 3 in the first direction, respectively. These slits 7 are arranged in parallel at intervals in the second direction. Each slit 7 is located between the frame part 5B and the circuit boards 17 adjacent to each other in the second direction or between the circuit boards 17 adjacent to each other, and, in this area, penetrates the product portion 3 in the thickness direction.

Accordingly, the slit 7 separates the circuit boards 17 adjacent to each other in the second direction. The circuit boards 17 located at the ends in the second direction are separated from the circuit boards 17 and the frame part 5B adjacent to the circuit boards in the second direction. Between the adjacent slits 7, the plurality of the circuit boards 17 are continuous in the first direction via the grooves 11.

The slit 7 should penetrate the collective board 1 in the thickness direction and the sectional shape of the slit may be appropriately set to that extent. In the present embodiment, the sectional shape of the slit 7 gradually narrows in width toward the intermediate portion from both surfaces of the product portion 3 in the thickness direction.

In the present embodiment, although the slit 7 reaches both the frame parts 5A at the ends in the first direction, the slit leaves portions continuous in the second direction without completely cutting the frame parts 5A. Accordingly, the frame part 5A at each end in the first direction defines the coupling portion 9. It should be noted that the slit 7 may be spanned only between the ends of the product portion 3 without reaching the frame parts 5A.

The coupling portion 9 couples the circuit boards 17 adjacent to each other in the second direction at least at one end of the product portion 3 in the first direction. The coupling portion 9 of the present embodiment is provided along the second direction at each end of the product portion 3 in the first direction in accordance with the frame part 5A. The coupling portion 9 integrally couples the circuit boards 17 arranged in a row along the second direction at each end of the product portion 3.

The plurality of the grooves 1 are arranged in parallel at intervals in the first direction on both sides of the collective board 1 in the thickness direction. The grooves 11 on both sides in the thickness direction are disposed so as to correspond to each other in the thickness direction. It should be noted that the grooves 11 may be provided on only one side of the collective board 1 in the thickness direction.

The plurality of the grooves 11 on each side are spanned between the ends of the product portion 3 in the second direction, respectively. In the present embodiment, the grooves 11 reach to both end edges of a pair of the frame parts 5B in the second direction.

Each groove 11 is located between the frame part 5A and the circuit boards 17 adjacent to each other in the first direction or between the circuit boards 17 adjacent to each other in the first direction, and the thin portions 23 being non-penetrating in the thickness direction are formed in those areas, the thin portions being portions of the product portion 3 thinned in the thickness direction. The individual circuit boards 17 may be separated by fracture of the thin portions 23. The non-penetrating form should have a non-penetrating portion and include a perforation having penetrating portions or the like.

The groove 11 should form the thin portion 23 in the product portion 3 and the sectional shape of the groove may be appropriately set to that extent. In the present embodiment, the groove 11 is a V-shaped groove and the sectional shape thereof is formed into a triangle shape, the width of which gradually narrows toward the thin portion 23 in the intermediate portion of the product portion 3 in the thickness direction.

### [Manufacturing method]

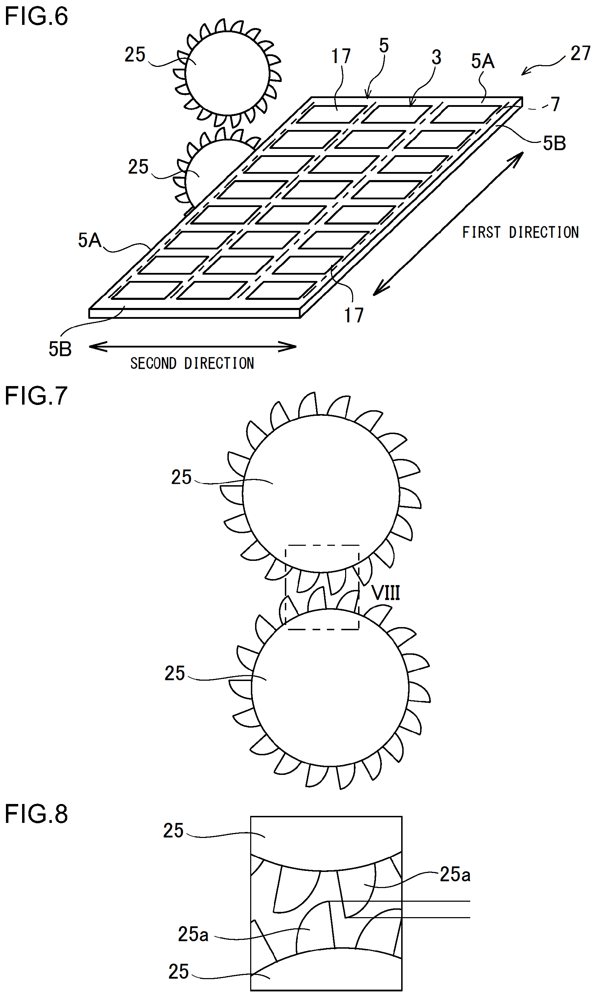

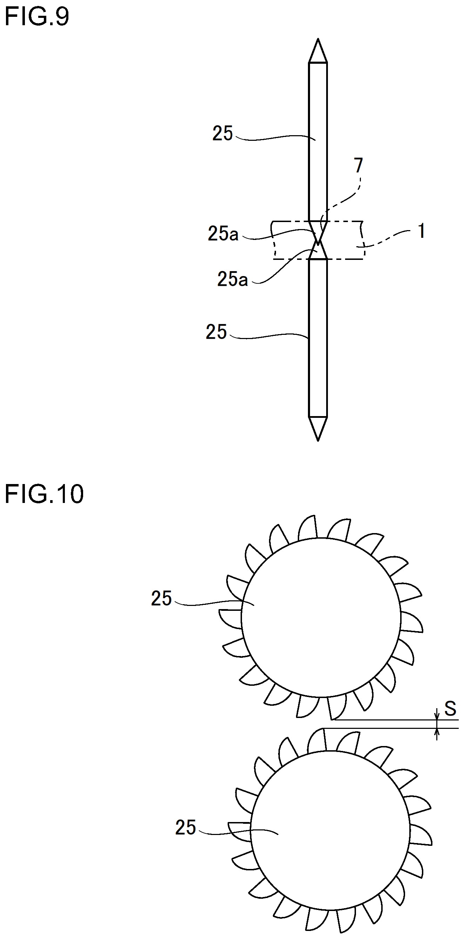

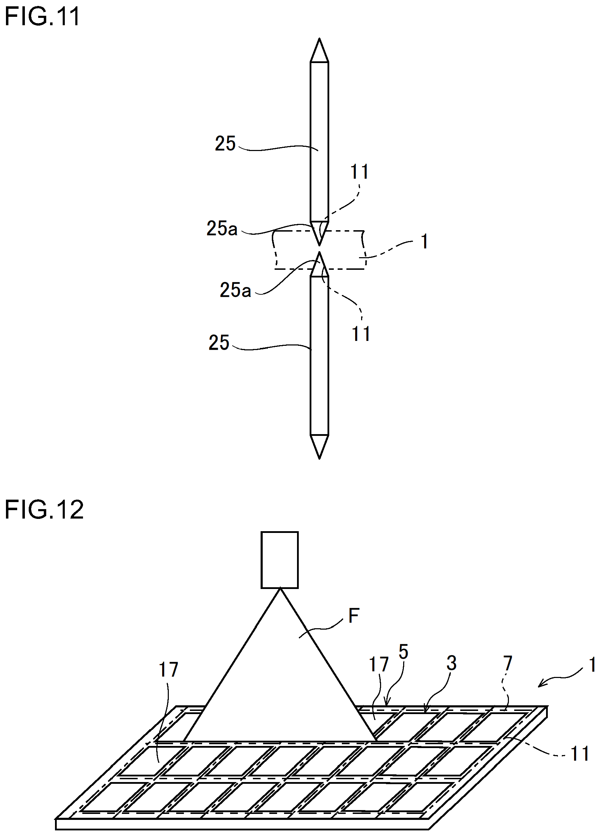

FIG. 5 is a schematic perspective view illustrating formation of the slits of the collective board 1 according to the embodiment of the present invention, and FIG. 6 is a schematic perspective view illustrating formation of the grooves 11 of the collective board 1. FIG. 7 is a side view illustrating cutters 25 at the time of the formation of the slit 7 in FIG. 5. FIG. 8 is an enlarged front view illustrating a portion VIII in FIG. 7. FIG. 9 is a schematic sectional view of the cutters 25 of FIG. 7. FIG. 10 is a side view of the cutters 25 at the time of the formation of the groove 11 in FIG. 6. FIG. 11 is a schematic sectional view of the cutters of FIG. 10.

A method of manufacturing the collective board 1 of the present embodiment manufactures semi-finished product 27 (FIG. 5, etc.) with the frame portion 5 around the product portion 3 and no slits 7 and no grooves 11. The manufacturing of the semi-finished product 27 is performed by laminating a circuit conductor 15a on a metal base 19 via an insulating layer 21 (see FIGS. 3 and 4).

The laminating the circuit conductor 15a may be performed by using a resin layer as an adhesive layer. The circuit conductor 15a to be laminated may be either un-patterned or patterned. If the circuit conductor 15a is un-patterned, the circuit conductor may be patterned by etching or the like after the laminating.

The slits 7 and the grooves 11 are formed in the semi-finished product 27 thus manufactured to obtain the collective board 1. In the present embodiment, the grooves 11 are formed after forming the slits 7. It, however, may form the slits 7 after forming the grooves 11.

When the slit 7 is formed, a pair of cutters 25 relatively move in the first direction while sandwiching the semi-finished product 27 from both sides in the thickness direction as illustrated in FIG. 5. At this time, the pair of the cutters 25 are separated from each other so as to avoid the frame parts 5A not to completely cut the frame parts 5A at both ends in the first direction and are brought close to each other between the ends of the product portion 3 in the first direction. It should be noted that, although the slit 7 is formed concurrently from both sides of the semi-finished product 27 in the present embodiment, the slit 7 may be formed by cutting the semi-finished product one side at a time with the cutter 25.

In the close of the pair of the cutters 25, the teeth 25a of the cutters 25 overlap each other in the first direction as illustrated in FIGS. 7 to 9. Accordingly, the slit 7 penetrating the semi-finished product 27 is surely formed. In the present embodiment, although the frame parts 5A are also partially cut, the coupling portions 9 are left in the frame parts 5A (see FIG. 2). It should be noted that the slit 7 may be provided only in a portion serving as the product portion 3.

The slit 7 is formed in each section between the circuit boards 17 in the second direction while relatively shifting the semi-finished product 27 in the second direction. As illustrated in FIG. 3, the slits 7 thus formed have a cross-section, the width of which gradually narrows from the surface to the intermediate portion of the semi-finished product 27 in the thickness direction according to the shape of the teeth 25a of the cutters 25.

When the groove 11 is formed, the semi-finished product 27 and the cutters 25 are relatively rotated so as to replace the first direction and the second direction of the semi-finished product 27 as illustrated in Fig. 6. With this, a moving direction of the cutters 25 coincides with the second direction of the semi-finished product 27.

In this state, the pair of the cutters 25 relatively move in the second direction while sandwiching the semi-finished product 27 from both sides in the thickness direction. When the groove 11 is formed, as illustrated in Figs. 10 and 11, the cutters 25 are separated so as to have a gap S corresponding to the thin portion 23 and, in this state, the cutters 25 are relatively moved with respect to the half-finished product 27. In addition, the groove 11 may be formed by cutting the half-finished product one side at a time with the cutter 25.

The groove 11 is formed in each section between the circuit boards 17 in the first direction while relatively shifting the semi-finished product 27 in the first direction. As illustrated in Fig. 4, the groove 11 thus formed is a V-shaped groove for forming the thin portion 23 in the semi-finished product 27 according to the shape of the teeth 25a of the cutters 25.

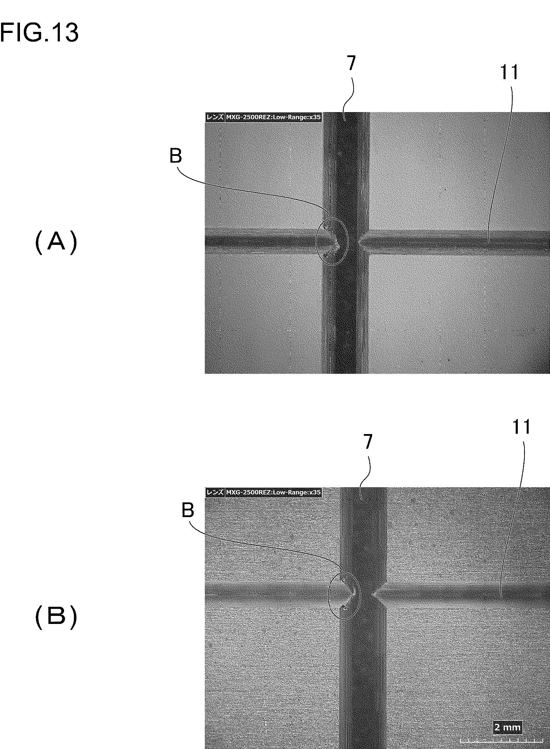

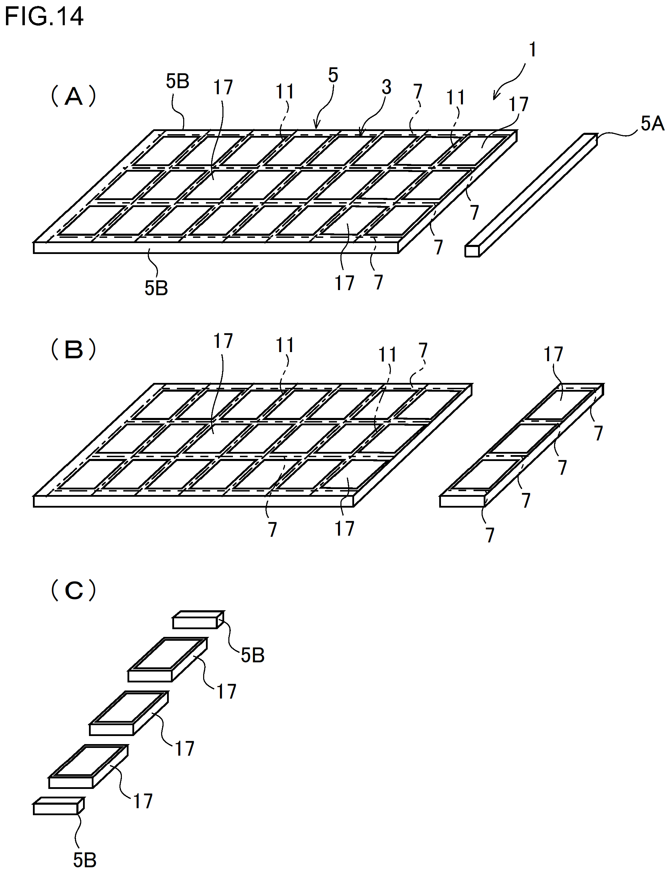

FIG. 12 is a schematic perspective view illustrating cleaning of the collective board 1. FIG. 13 is a set of photographs illustrating an enlarged intersection of the slit 7 and the groove 11 of the collective board in which FIG. 13(A) is a front surface and FIG. 13(B) is a rear surface. In FIG. 12, the slits 7 and the grooves 11 are illustrated only by broken lines. The same holds for FIG. 14.

As illustrated in FIG. 12, the collective board 1 in which the slits 7 and the grooves 11 are formed is cleaned by injecting the fluid F. The cleaning of the present embodiment is high-pressure water washing and pure water is used for the fluid F. The fluid F is not limited to the pure water and may be an aqueous solution of isopropyl alcohol or the like as long as the fluid performs cleaning by injection.

This cleaning removes burrs and chips on the collective board 1 generated when the slits 7 and the grooves 11 are formed. In the present embodiment, since the grooves 11 are formed after forming the slits 7, the burrs B are positioned so as to protrude into the slits 7 as illustrated in FIG. 13.

The burrs B are, therefore, surely removed by the fluid F passing through the slits 7. In particular, since the slits 7 of the present embodiment gradually narrow in width toward the intermediate portion in the thickness direction, flow velocity of the fluid F increases to easily remove the burrs.

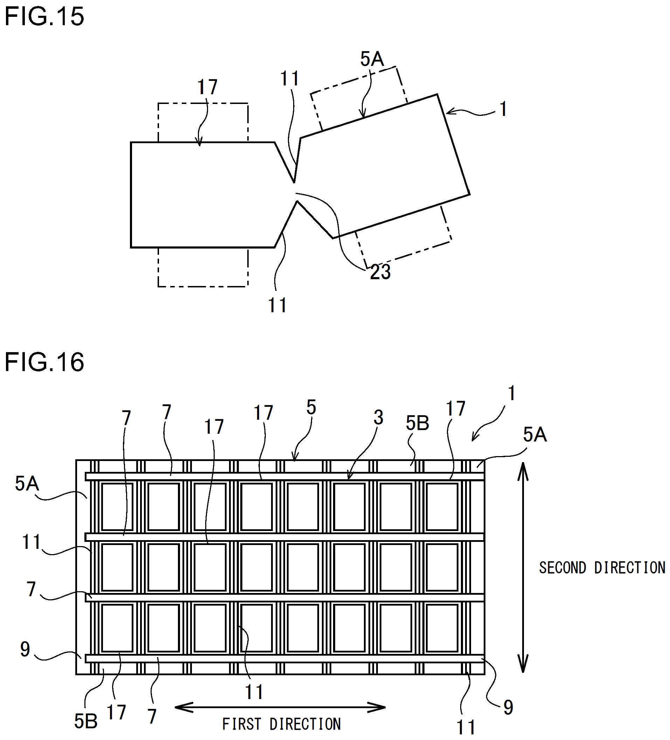

FIGS. 14(A) to 14(C) are perspective views illustrating a method of manufacturing the circuit board 17. FIG. 15 is a schematic sectional view illustrating the method of manufacturing the circuit board 17.

As illustrated in FIGS. 14(A) to 14(C), the individual circuit boards 17 are obtained from the collective board 1 after the cleaning. In the present embodiment, as illustrated in FIG. 15, the frame parts 5A and the circuit boards 17 are sequentially divided by holding both sides of the groove 11 and bending the collective board 1 along the groove 11 from one end of the collective board 1 in the first direction.

In particular, the frame part 5A is divided as illustrated in FIG. 14(A), first. As illustrated in FIG. 15, in this division, it holds the frame part 5A located at one end in the first direction and the circuit boards 17 adjacent to this frame part in the first direction with interposition of the groove 11, respectively, and bends them along the groove 11. Accordingly, the thin portion 23 between the frame part 5A and the circuit boards 17 is fractured to divide the frame part 5A.

The holding is performed for each row along the second direction, and the frame part 5A to be separated is held on one side as a whole along the second direction, and the circuit boards 17 adjacent to the frame part 5A in the first direction are collectively held on the other side.

By dividing the frame part 5A, the circuit boards 17 located at one end in the first direction are coupled in the second direction only at the coupling portion 9 on the frame part 5A located at the other end in the first direction.

In this state, the circuit boards 17 located at one end in the first direction of the collective board 1 are divided as illustrated in FIG. 14(B). Similarly to FIG. 14(A), in this division, it holds the circuit boards 17 located at one end in the first direction and the circuit boards 17 adjacent to this circuit boards in the first direction, and bends them along the groove 11. With this, the thin portion 23 is fractured to divide the circuit boards 17 located at one end in the first direction.

The holding here is performed for each row along the second direction. Thus, the circuit boards 17 located at one end in the first direction are divided as a row along the second direction. The plurality of the circuit boards 17 thus divided are separated from each other and separated with respect to the frame parts 5B by the slits 7 in the second direction as illustrated in FIG. 14(C), to be obtained as individual circuit boards 17 separated from each other.

By repeating this division, all the circuit boards 17 of the collective board 1 are separated and obtained.

As mentioned above, the collective board 1 of the present embodiment is provided with the product portion 3 in which the plurality of the circuit boards 17 are juxtaposed in the first direction and the second direction intersecting each other in the lattice shape, the slit 7 spanning between at least the ends of the product portion 3 in the first direction and penetrating, in the thickness direction, to separate the circuit boards 17 adjacent to each other in the second direction, the coupling portion 9 coupling the circuit boards adjacent to each other in the second direction at least at one end of the product portion 3 in the first direction, and the grooves 11 spanning between the ends of the product portion 3 in the second direction and being non-penetrating in the thickness direction to reduce the thickness between the circuit boards 17 and the coupling portion 9 adjacent to each other in the first direction and between the circuit boards 17 adjacent to each other in the first direction.

The collective board 1, therefore, enables the circuit boards 17 to be integrally handled through the coupling portion 9. Further, since the individual circuit boards 17 are connected by the grooves 11 only in the first direction in the collective board 1, the individual circuit boards 17 are easily obtained only by the fracture at the grooves 11. It is, therefore, possible to improve work efficiency for obtaining the individual circuit boards 17 from the collective board 1 in which the circuit boards 17 are juxtaposed in the lattice shape.

The coupling portion 9 is provided along the second direction at each end of the product portion 3 in the first direction, so that the handling becomes easier.

The method for manufacturing the collective board 1 forms the grooves 11 after forming the slits 7 on the semi-finished product 27 having the product portion 3, so that the burrs B are positioned in the slits 7 and the burrs B are easily removed through the slits 7.

In the present embodiment, since the fluid F is injected to the product portion 3, the burrs B are surely removed. In particular, the slits 7 gradually narrows in width toward the intermediate portion of the product portion 3 in the thickness direction, so that the flow velocity of the fluid is increased to easily remove the burrs B.

The method for manufacturing the circuit board 17 holds both sides of the respective grooves 11 in the first direction of the collective board 1 and fractures between the circuit boards 17 and the coupling portion 9 adjacent to each other and between the circuit boards 17 adjacent to each other. With this, the individual circuit boards 17 are separated to easily obtain the individual circuit boards 17.

Since the holding is performed for each row along the second direction, the plurality of the circuit boards 17 in the row along the second direction are individually separated by one fracture.

### EMBODIMENT 2

FIG. 16 is a plan view of a collective board according to the embodiment 2 of the present invention. In addition, the embodiment 2 is in common with the embodiment 1 in the basic structure and the corresponding components are represented with the same reference numerals, to omit redundant description.

In a collective board 1 of the present embodiment, frame parts 5A at one end in the first direction are cut by slits 7 and there is no continuous portion between circuit boards 17 adjacent to each other in the second direction at one end in the first direction. The others are the same as those in the embodiment 1.

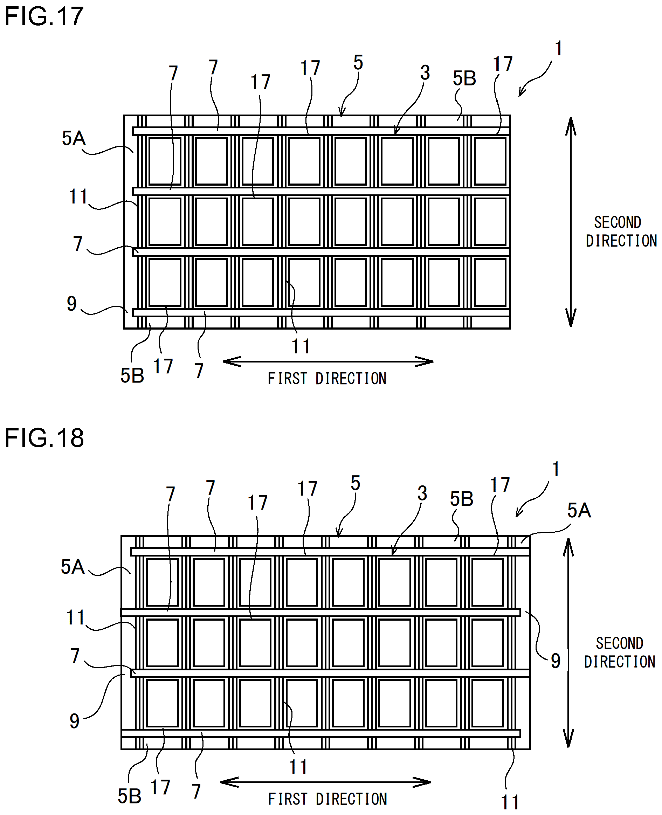

FIG. 17 is a plan view of a collective board according to a modification of the embodiment 2. FIG. 18 is a plan view of a collective board according to another modification of the embodiment 2.

In the modification of FIG. 17, the frame part 5A at one end in the first direction is omitted relative to the embodiment 2. In the modification of FIG. 18, coupling portions 9 are alternately provided in the frame parts 5A at both ends in the first direction.

In the modification of FIG. 18, slits 7 adjacent to each other in the second direction cut the frame parts 5A located at different ends in the first direction, respectively, to separate them in the second direction. With this, the coupling portions 9 couples a pair of the circuit boards 17 adjacent to each other in the second direction at each end in the first direction. The present embodiment couples upper two rows in FIG. 18 among the circuit boards 17 that are three rows in the second direction by the coupling portion 9 at one end in the first direction and couples lower two rows by the coupling portion 9 at the other end in the first direction. Then, the upper and lower circuit boards 17 are coupled to each other via the both coupling portions 9 and the circuit boards 17 of a vertically intermediate row in FIG. 18.

The second embodiment and the modifications thereof also provides the same effects as those of the first embodiment.

### DESCRIPTION OF NUMERALS

- 1: Collective board
- 3: Product portion
- 7: Slit
- 9: Coupling portion
- 11: Groove
- 13: Insulating substrate
- 15: Circuit pattern
- 17: Circuit board
- 23: Thin portion

## Claims

1. A collective board comprising:
a product portion in which a plurality of circuit boards each having a circuit pattern on an insulating substrate are juxtaposed in a first direction and a second direction intersecting each other in a lattice shape;
a slit spanning between at least ends of the product portion in the first direction and penetrating, in a thickness direction, a portion between the circuit boards of the product portion adjacent to each other in the second direction;
a coupling portion coupling the circuit boards adjacent to each other in the second direction at least at one end of the product portion in the first direction; and
grooves spanning between ends of the product portion in the second direction, being located between the circuit boards and the coupling portion adjacent to each other in the first direction and between the circuit boards adjacent to each other in the first direction, and being non-penetrating in the thickness direction.

2. The collective board of claim 1, wherein
the coupling portion is provided along the second direction at each end of the product portion in the first direction.

3. A method for manufacturing a collective board, the collective board having a product portion in which a plurality of circuit boards each having a circuit pattern on an insulating substrate are juxtaposed in a first direction and a second direction intersecting each other in a lattice shape, a slit spanning between at least ends of the product portion in the first direction and penetrating, in a thickness direction, a portion between the circuit boards of the product portion adjacent to each other in the second direction, a coupling portion coupling the circuit boards adjacent to each other in the second direction at least at one end of the product portion in the first direction, and grooves spanning between ends of the product portion in the second direction, being located between the circuit boards and the coupling portion adjacent to each other in the first direction and between the circuit boards adjacent to each other in the first direction, and being non-penetrating in the thickness direction, comprising:
forming the slit and the grooves on a semi-finished product having the product portion.

4. The method for manufacturing a collective board according to claim 3, wherein
the grooves are formed after forming the slit.

5. The method for manufacturing a collective board according to claim 3 or 4, further comprising:
injecting a fluid to the product portion.

6. The method for manufacturing a collective board according to claim 5, wherein
the slit is gradually narrowed in width toward an intermediate portion of the product portion in the thickness direction.

7. A method for manufacturing a circuit board using a collective board, the collective board having a product portion in which a plurality of circuit boards each having a circuit pattern on an insulating substrate are juxtaposed in a first direction and a second direction intersecting each other in a lattice shape, a slit spanning between at least ends of the product portion in the first direction and penetrating, in a thickness direction, a portion between the circuit boards of the product portion adjacent to each other in the second direction, a coupling portion coupling the circuit boards adjacent to each other in the second direction at least at one end of the product portion in the first direction, and grooves spanning between ends of the product portion in the second direction, being located between the circuit boards and the coupling portion adjacent to each other in the first direction and between the circuit boards adjacent to each other in the first direction, and being non-penetrating in the thickness direction, comprising:
holding both sides of the respective grooves in the first direction to fracture between the circuit boards and the coupling portion adjacent to each other and between the circuit boards adjacent to each other.

8. A method of manufacturing a circuit board using the method of manufacturing the circuit board according to claim 7, wherein
the holding is performed for each row along the second direction.
